# EUROPÄISCHE PATENTSCHRIFT

(11) **EP 1 553 701 B1**
(45) Veröffentlichungstag und Bekanntmachung des Hinweises auf die Patenterteilung: **29.08.2007**
(21) Anmeldenummer: 04090497.1
(22) Anmeldetag: 17.12.2004
(51) Int. Cl.: H03K 3/03

(54) **Schaltungsanordnung zur Erzeugung eines digitalen Clocksignals**
Circuit arrangement for generating a digital clock signal
Circuit de génération d'un signal numérique d'horloge

(30) Priorität: 19.12.2003 US 531346 P; 05.04.2004 US 818928
(43) Veröffentlichungstag der Anmeldung: 13.07.2005
(73) Patentinhaber: Infineon Technologies AG, 81669 München (DE)
(72) Erfinder: Martin, Friedrich, 45892 Gelsenkirchen (DE); Grewing, Christian, 19146 Sollentuna (SE); Malik, Rashid Latif, 47198 Duisburg (DE)
(74) Vertreter: Müller, Wolfram Hubertus

(56) Entgegenhaltungen:
- EP-A- 0 293 045
- US-A- 6 069 536

## Beschreibung

Die Erfindung betrifft eine Schaltungsanordnung zur Erzeugung eines digitalen Clocksignals. Insbesondere betrifft die Erfindung eine Schaltungsanordnung zur Erzeugung eines digitalen Clocksignals im kHz-Bereich mit sehr kleinen Strömen im µA Bereich, die z.B. im Schlafmodus eines integrierten Schaltkreises Anwendung findet.

### Hintergrund der Erfindung

Zur Erzeugung eines digitalen Clocksignals ist es bekannt, Quarz-Oszillatoren zu verwenden. Quarz-Oszillatoren zeichnen sich durch eine hohe Frequenzkonstanz aus. Nachteilig liegt jedoch ein relativ hoher Stromverbrauch vor.

### Aufgabe der Erfindung

Der vorliegenden Erfindung liegt die Aufgabe zugrunde, eine Schaltungsanordnung zur Erzeugung eines digitalen Clocksignals zur Verfügung zu stellen, die ohne einen Quarz-Oszillator auskommt. Die Schaltungsanordnung soll sich dabei durch einen geringen Stromverbrauch auszeichnen.

### Zusammenfassung der Erfindung

Diese Aufgabe wird erfindungsgemäß durch eine Schaltungsanordnung gelöst, die aufweist: eine Transistorschaltung mit einem ersten, n-Kanal FET-Transistor und einem zweiten, p-Kanal FET-Transistor, die in Reihe geschaltet sind; einen Komparator mit einem positiven Komparatoreingang, einem negativen Komparatoreingang und einem Komparatorausgang; eine Einrichtung zur Bereitstellung zweier Schaltschwellen, die an ihrem Ausgang alternativ zwei Schaltschwellen für den Komparator bereitstellt, wobei der Ausgang der Einrichtung mit dem negativen Eingang des Komparators verbunden ist; und eine Kapazität, die über die die beiden FET-Transistoren alternierend ge- und entladen wird, wobei die an der Kapazität anliegende Spannung dem positiven Komparatoreingang zugeführt wird. Die Ausgangsspannung des Komparators stellt ein digitales Clocksignal bereit, das auf den Eingang der Einrichtung zur Bereitstellung zweier Schaltschwellen und auf die Gate-Anschlüsse des ersten und zweiten FET-Transistors zurückgeführt wird.

Die Einrichtung zur Bereitstellung zweier Schaltschwellen, bei der es sich bevorzugt um einen Inverter handelt, stellt an ihrem Ausgang je nach Eingangssignal eine von zwei Schaltschwellen für den negativen Komparatoreingang zur Verfügung. Die Kapazität C wird über einen der FET-Transistoren mit einem Konstantstrom aufgeladen und über den anderen der FET-Transistoren mit einem Konstantstrom entladen. Die am positiven Komparatoreingang anliegende Spannung der Kapazität und die am negativen Komparatoreingang anliegende Schaltschwelle bestimmen den Zustand des Komparatorausgangs. Der Komparator wird als Spannungsvergleicher eingesetzt und stellt an seinem Ausgang ein digitales Clocksignal zur Verfügung. Durch die Verwendung von integrierten Bauelementen und den Verzicht auf externe Komponenten wie externe Quarz-Oszillatoren kann eine sehr geringe Stromaufnahme erreicht werden. Dies gilt insbesondere für den Fall, dass die integrierten Bauelemente in CMOS-Technologie ausgeführt sind.

In einer bevorzugten Ausgestaltung der Erfindung weist die Schaltungsanordnung zusätzlich Mittel zur Einstellung der Frequenz des Ausgangssignals des Komparators auf, wobei diese Mittel die Spannung am positiven Komparatoreingang beeinflussen. Bei diesem Mittel handelt es sich in einer bevorzugten Ausführungsform um eine Einrichtung zur Steuerung des Strom durch den ersten FET-Transistor und den zweiten FET-Transistor. Insbesondere weist die Schaltungsanordnung eine erste Stromquelle zur Bereitstellung eines Stroms für den ersten FET-Transistor und eine zweite Stromquelle zur Bereitstellung eines Stromes durch den zweiten FET-Transistor auf, wobei die Einrichtung zur Steuerung des Stroms die erste Stromquelle und/oder die zweite Stromquelle steuert. Unter Steuerung im Sinne der vorliegenden Erfindung wird dabei sowohl ein Steuern (ohne Rückkopplung) als auch ein Regeln (mit Rückkopplung) verstanden.

Durch die Steuerung des Stroms durch die Stromquellen der FET-Transistoren wird der Auflade- bzw. Entladevorgang der Kapazität beeinflusst, deren Spannung dem positiven Komparatoreingang zugeführt wird. Durch eine Variation der Ströme bzw. einer Steuerung der Stromquellen kann dementsprechend die Frequenz des Ausgangssignals des Komparators beeinflusst bzw. eingestellt werden.

In einer alternativen Ausgestaltung werden die Mittel zur Einstellung der Frequenz durch eine Einrichtung zur Einstellung der Kapazität bereitgestellt. Hierbei weist die Kapazität bevorzugt eine Mehrzahl von Teilkapazitäten auf, die mittels Schalter parallel zueinander schaltbar sind, wobei die Einrichtung zur Einstellung der Kapazität diese Teilkapazitäten zu- oder wegschaltet. Es handelt sich bei der Einrichtung zur Einstellung der Kapazität mit anderen Worten um eine Trim-Logik, die Teilkapazitäten zu- oder wegschaltet.

Eine Beeinflussung der Frequenz des Clocksignals erfolgt bei dieser Erfindungsvariante insofern, als bei einer größeren Kapazität der durch die beiden FET-Transistoren bereitgestellte Auflade- bzw. Entladestrom zu einem langsameren Spannungsauf- bzw. abbau an der Kapazität und damit am positiven Komparatoreingang führt. Dementsprechend geht die Frequenz des Clocksignals runter. In entsprechender Weise erhöht sich die Frequenz des Clocksignals bei einer Reduzierung der Kapazität.

Es kann vorgesehen sein, dass die Einrichtung zur Einstellung der Kapazität bzw. die Einrichtung zur Steuerung des Stromes - je nach dem, welche dieser beiden Möglichkeiten zur Beeinflussung der Frequenz des Clocksignal genutzt wird - in bestimmten zeitlichen Abständen einen Vergleich der aktuellen Frequenz des Clocksignals mit einer Referenzfrequenz vornimmt. Die Referenzfrequenz wird beispielsweise durch einen externen Quarzoszillator bereitgestellt. Da jedoch nur kurzzeitig ein solcher Abgleich erfolgt, kann der Quarzoszillator nach einem entsprechenden Abgleich wieder ausgeschaltet werden, so dass durch den zusätzlichen Quarzoszillator ein nur geringer Stromverbrauch vorliegt.

Die Ströme durch den ersten FET-Transistor und den zweiten FET-Transistor sind bevorzugt betragsmäßig gleich. Die Kapazität wird dann durch gleich große Konstantströme aufgeladen bzw. entladen. Des weiteren sind der erste FET-Transistor und der zweite FET-Transistor bevorzugt komplementär zueinander ausgebildet, was die Bereitstellung von betragsmäßig gleich großen Strömen sicherstellt.

### Kurze Beschreibung der Zeichnungen

Die Erfindung wird nachfolgend unter Bezugnahme auf die Figuren anhand eines Ausführungsbeispieles näher erläutert. Es zeigen:
- Figur 1: eine Schaltungsanordnung zur Erzeugung eines digitalen Clocksignals,
- Figur 2: den Kurvenverlauf der Spannungen am positiven Komparatoreingang, am negativen Komparatoreingang und am Komparatorausgang des Komparators der Schaltungsanordnung der Figur 1, und
- Figur 3: eine detaillierte Darstellung der Kapazität der Schaltungsanordnung der Figur 1.

### Beschreibung eines bevorzugten Ausführungsbeispiels

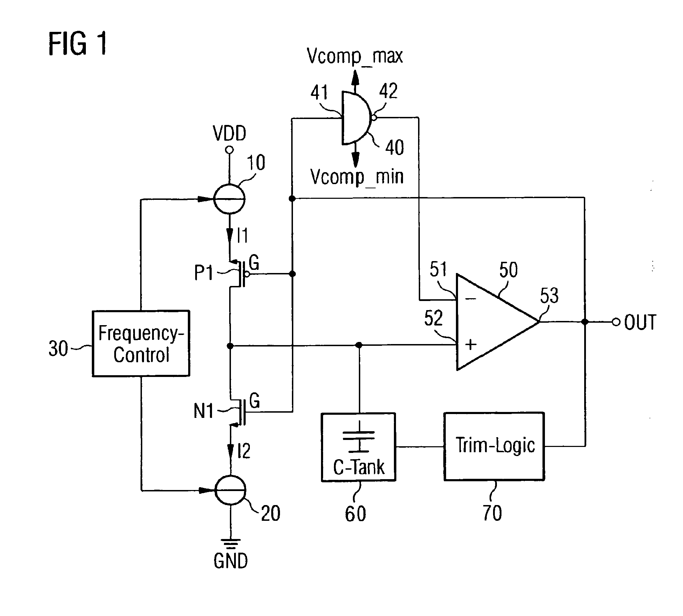

Die Schaltungsanordnung der Figur 1 weist zwei Schalttransistoren P1, N1 auf, bei denen es sich um einen P-Kanal FET-Transistor (Feldeffekt-Tranistor) P1 und einen N-Kanal FET-Tansister N1 handelt. Die beiden Transistoren P1, N1 sind ebenso wie die weiteren Schaltungsteile der Schaltungsanordnung bevorzugt in CMOS-Technologie ausgeführt.

Die beiden Schalttransistoren N1, P1 sind zueinander in Reihe geschaltet. Der Source-Anschluss des P-Kanal-Transistors P1 ist über eine erste Stromquelle 10 mit einer Versorgungsspannung VDD verbunden. Der Source-Anschluss des N-Kanal-Transistors N1 ist über eine zweite Stromquelle 20 mit Ground verbunden. Die Drain-Anschlüsse sind zum einen miteinander und zum anderen mit dem einen Anschluss einer Kapazität 60 verbunden, die nachfolgend auch als C-Tank bezeichnet wird.

Es ist ein Komparator 50 vorgesehen, der einen negatven Komparatoreingang 51, einen positiven Komparatoreingang 52 und einen Komparatorausgang 53 aufweist. Der positive Komparatoreingang 52 ist mit dem einen Anschluss der Kapazität 60 verbunden, so dass die an der Kapazität 60 anliegende Spannung die Spannung am positiven Komparatoreingang 52 bestimmt. Der negative Komparatoreingang 51 ist mit dem Ausgang 42 eines Inverters 40 verbunden. Der Ausgang 53 des Komparators kann an einem Bezugspunkt OUT als Clocksignal abgegriffen werden. Des weiteren wird der Ausgang des Komparators 53 zurückgeführt zum einen auf die Gate-Anschlüsse der Schalttransistoren P1, N1 und zum anderen auf den Steuereingang 41 des Inverters 40.

Der Inverter 40 besteht beispielsweise aus zwei in Reihe geschalteten N-Kanal- und P-Kanal-Transistoren, deren Gate-Spannungen durch die Spannung am Eingang 41 bestimmt wird. Der eine der Transistoren ist mit einer Spannung Vcomp-max, der andere der Transistoren mit einer Spannung Vcomp-min verbunden. Je nach dem, ob am Eingang 41 des Inverters 40 ein HIGH- oder in LOW-Signal anliegt, wird die Spannung Vcomp-max oder die Schaltung Vcomp-min an den Ausgang 42 durchgeschaltet, während der jeweils andere Transistor sperrt (CMOS-Inverter).

Die Spannungen Vcomp-max und Vcomp-min stellen zwei Schaltschwellen für den Komparator 50 zur Verfügung, wobei der Inverter 40 an seinem Ausgang 42 je nach Eingangssignal entweder die Spannung Vcomp-max oder Vcomp-min als Schaltschwelle zur Verfügung stellt.

Die Schaltungsanordnung weist des weiteren zwei optionale Einrichtungen 30, 70 auf. Zum einen handelt es sich um eine Frequenzkontrolleinrichtung 30, die eine Regelung oder Steuerung der Stromquellen 10, 20 ermöglicht. Wie noch ausgeführt, lässt sich über eine Regelung oder Steuerung der Stromquellen 10, 20 die Ausgangsfrequenz des Oszillators strom- oder spannungsgesteuert einstellen, sofern dies erforderlich ist. Eine weitere Möglichkeit zur Beeinflussung der Frequenz des Clocksignals wird durch eine Trim-Logik 70 bereitgestellt, die je nach Bedarf Kapazitäten des C-Tanks hinzu- oder wegschalten kann. Auch hierüber kann die Ausgangsfrequenz des Oszillators eingestellt werden. Die Genauigkeit der Frequenzeinstellung ist dabei durch den kleinsten technologisch sinnvoll zu realisierenden Kapazitätswert gegeben.

Der Einfluss der Trim-Logik 70 auf den C-Tank 60 ist anhand der Figur 3 näher dargestellt. Danach besteht der C-Tank 60 aus mehreren Teilkapazitäten 61, 62, 63. Die Kapazitäten 62, 63 sind über Schalter S1, S2 parallel zu der Kapazität 61 schaltbar. Ein Schalten erfolgt dabei über die Trim-Logik 70, die eine digitale Ansteuerung der Schalter S1, S2 vornimmt.

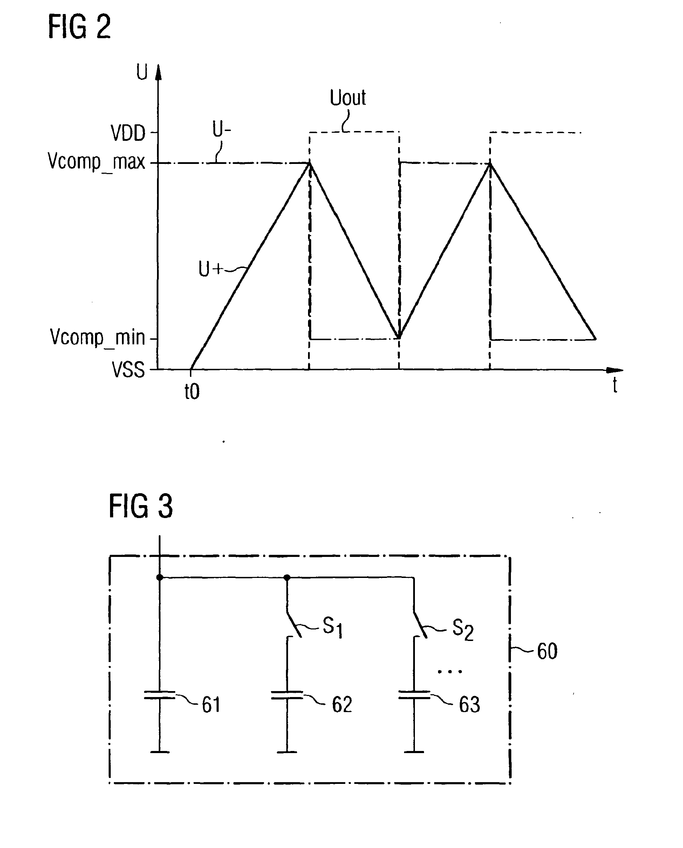

Nachfolgend wird die Funktionsweise der beschriebenen Schaltung beschrieben, wobei ergänzend auf die Figur 2 Bezug genommen wird. Die Bedeutung der optional vorgesehenen Frequenzkontrolleinrichtung 30 und Trim-Logik 70 wird dabei zunächst nicht betrachtet.

Über die Schalttransistoren N1, P1 wird die Kapazität 60 mit einem Konstantstrom I1 (bei leitendem Transistor P1) aufgeladen bzw. mit einem gleich großen Konstantstrom I2 (bei leitendem N-Kanal-Transistor N1) entladen. Der Takt wird dabei durch das Ausgangssignal des Komparators 50 vorgegeben, dessen Ausgang 53 mit den Gate-Anschlüssen der Transistoren P1, N1 verbunden ist. Abhängig vom Ladezustand liegt an der Kapazität 60 somit eine sich verändernde Spannung an. Diese Spannung wird dem positiven Komparatoreingang 52 zugeführt. Die Spannung am negativen Komparatoreingang 51 wird durch den Inverter 40 bereitgestellt, wobei alternierend eine der beiden Werte Vcomp-max und Vcomp-min bereitgestellt wird. Die am positiven Komparatoreingang 52 anliegende Spannung an der Kapazität 60 und die am negativen Komparatoreingang 51 anliegende Spannung bestimmen den Zustand des Komparatorausgangs 53 und den Zustand der Kapazität 60 nach folgender Tabelle:

| Komparatoreingang | Komparatorausgang | Ladezustand C |
|---|---|---|
| Spannung + > Spannung - | HIGH | Entladen (I2) |
| Spannung + < Spannung - | LOW | Laden (I1) |

Wenn die Spannung am positiven Komparatoreingang 52 größer ist als am negativen Komparatoreingang 51, liegt am Ausgang des Komparators 50 das Signal "HIGH" vor. Wenn die Spannung am positiven Komparatoreingang 52 kleiner ist als die Spannung am negativen Komparatoreingang 51, liegt am Komparatorausgang die Spannung "LOW" vor. Dies korrespondiert jeweils mit einem Laden bzw. Entladen der Kapazität 60.

Um ein sicheres Umschalten des Komparators 50 zu gewährleisten, muss für die Schaltschwellen Vcomp-max und Vcomp-min, die vom Inverter 40 bereitgestellt werden, folgende Bedingung gelten:

V_{DD} > Vcomp-max > Vcomp-min > V_{SS}. V_{DD} stellt dabei die positive Betriebsspannung und V_{SS} die negative Betriebsspannung dar, wobei letztere in der Regel gleich Ground ist.

Die Figur 2 zeigt beispielhaft den Verlauf der Spannungen an den Komparatoreingängen 51, 52 und am Komparatorausgang 53 in Abhängigkeit von der Zeit. Die Spannung am negativen Komparatoreingang ist gepunktet dargestellt und mit U-gekennzeichnet. Die Spannung am positiven Komparatoreingang ist als feste Linie dargestellt und mit U+ gekennzeichnet. Die Spannung am Komparatorausgang ist gestrichelt dargestellt und mit U_{OUT} gekennzeichnet.

Zum Zeitpunkt t0 sei die Kapazität 60 vollständig entladen und der Komparatorausgang 53 auf LOW geschaltet. Damit liegt über dem Inverter 40 der Wert Vcomp-max als Schaltschwelle am negativen Komparatoreingang 51 an. Da der Komparatorausgang 53 auf LOW geschaltet ist, ist des weiteren der P-Kanal-Transistor P1 leitend, während der N-Kanal-Transistor N1 sperrt. Die Kapazität 60 wird nun so lange mit dem Strom I1 der Stromquelle 10 über den leitenden P-Kanal-Transistor aufgeladen P1, bis für die Spannung am positiven Komparatoreingang 52 gilt, dass diese Spannung größer ist als Vcomp-max am negativen Komparatoreingang 51. Der Komparator 50 schaltet daraufhin den Ausgang auf logisch HIGH, d.h. U_{OUT} gleich V_{DD}.

Gleichzeitig wechselt die Schaltschwelle am Ausgang des Inverters 42 auf Vcomp-min. Des weiteren wird gleichzeitig der P-Kanal-Transistor P1 gesperrt, während der N-Kanal-Transistor N1 leitend wird. Daraufhin wird die Kapazität 60 mit dem Strom I2 entladen und damit die Spannung an der Kapazität 60 abgebaut, bis am positiven Komparatoreingang 52 die Schaltschwelle Vcomp-min unterschritten wird. Wenn dies erfolgt, schaltet der Komparator am Ausgang auf logisch LOW, d.h. U_{OUT} gleich V_{SS} und die beschriebene Abfolge beginnt von Neuem.

Es sei noch erwähnt, dass Komparator 50 entsprechend den Eigenschaften eines Komparators am Ausgang 53 den Wert V_{DD} (logisch HIGH) ausgibt, wenn die Spannung am negativen Komparatoreingang 51 kleiner ist als die Spannung am positiven Komparatoreingang 52. Im anderen Fall liegt die Ausgangsspannung des Komparators 50 bei V_{SS} (logisch LOW). Je nach verwendeter Logikfamilie können auch andere Ausgangsspannungen vorgesehen sein.

Die beschriebene Schaltung stellt somit am Ausgang OUT ein digitales Clocksignal zur Verfügung. Bevorzugt liegt die Clockfrequenz im Kilohertzbereich, beispielsweise bei 400 kHz. Die Stromaufnahme liegt bevorzugt im µA-Bereich, beispielsweise bei ca. 40 pA. Die Bauelemente sind wie bereits erwähnt bevorzugt in CMOS-Technologie ausgeführt. Die Ströme I1, I2 durch die Transistoren P1, N1 werden beispielsweise aus einer gepufferten Bandgap-Referenz über Stromspiegel generiert. Die Schaltschwellen Vcomp-max und Vcomp-min werden beispielsweise über einen hochohmigen Spannungsteiler aus der selben Referenz erzeugt.

Es wird nun noch auf die Möglichkeit einer Frequenzeinstellung durch die Fequenzkontrolleinrichtung 30 und die Trim-Logik 70 eingegangen. Durch die Frequenzkontrolleinrichtung 30 kann der Strom I1, I2 durch die Stromquellen 10, 20 gesteuert oder geregelt werden. Durch eine Änderung des Stroms I1, I2 wird der Kondensator 60 in unterschiedlichem Maße geladen bzw. entladen. Dies führt zu unterschiedlichem Zeitverläufen, bis am positiven Komparatoreingang 52 die Schaltschwelle Vcomp-max bzw. Vcomp-min erreicht ist. Dem entsprechend ändert sich die Ausgangsfrequenz des Komparators 50.

Ein vergleichbarer Effekt kann auch durch die Trim-Logik 70 erreicht werden, die wie in Bezug auf die Figur 3 erläutert Teilkapazitäten 61,62, 63 des C-Tanks 60 hinzu- bzw. wegschaltet. Die Größe der Kapazität beeinflusst die Zeit, bis bei konstantem Lade- bzw. Entladestrom I1, I2 am positiven Komparatoreingang 52 die Spannung Vcomp-max - Vcomp-min erreicht wird, die am negativen Komparatoreingang 51 als Schaltschwelle anliegt. Dementsprechend kann auch durch Hinzu- bzw. Wegschalten von Kapazitäten die Ausgangsfrequenz beeinflusst werden.

Wie bereits erwähnt, sind die Frequenzkontrolleinrichtung 30 und die Trim-Logik 70 optional. Wahlweise können auch beide kombiniert eingesetzt werden.

In einer weiteren Ausgestaltung der Schaltungsanordnung ist die Frequenzkontrolleinrichtung 30 und/oder die Trim-Logik 70 mit einem externen Resonator, insbesondere einem Quarz-Oszillator koppelbar. Der externe Oszillator wird jedoch nur in bestimmten zeitlichen Abständen angeschaltet. Er dient dann der Bereitstellung eines Referenzwertes für eine gewünschte Ausgangsfrequenz. Die Frequenzkontrolleinrichtung 30 bzw. die Trim-Logik 70 vergleicht dabei die aktuelle Frequenz des Clocksignals mit einer gewünschten Vergleichsfrequenz, die durch den externen Resonator bereitgestellt wird, und ändert ggf. die Frequenz zur Erreichung einer Übereinstimmung. Der externe Resonator wird dann wieder abgeschaltet, so dass der Stromverbrauch des externen Resonators gering ist.

Die Erfindung beschränkt sich in ihrer Ausgestaltung nicht auf das vorstehend dargestellte Ausführungsbeispiel.

Beispielsweise können die einzelnen Bauelemente einer anderen Logikfamilie als CMOS angehören. Auch können beispielsweise die Schaltschwellen Vcomp-max, Vcomp-min durch andere Schaltungsmittel als einen Inverter bereitgestellt werden.

## Patentansprüche

1. Schaltungsanordnung zur Erzeugung eines digitalen Clocksignals mit:
- einer Transistorschaltung mit
o einem ersten, n-Kanal FET-Transistor (N1) und
o einem zweiten, p-Kanal FET-Transistor (P1),
o die in Reihe geschaltet sind,
- einem Komparator (50) mit einem positiven Komparatoreingang (52), einem negativen Komparatoreingang (51) und einem Komparatorausgang (53),
- einer Einrichtung (40) zur Bereitstellung zweier Schaltschwellen, die an ihrem Ausgang (42) alternativ zwei Schaltschwellen für den Komparator (50) bereitstellt, wobei der Ausgang (42) der Einrichtung (40) mit dem negativen Eingang (51) des Komparators (50) verbunden ist, und
- einer Kapazität (60), die über die beiden FET-Transistoren (N1, P1) alternierend ge- und entladen wird, wobei die an der Kapazität (C) anliegende Spannung dem positiven Komparatoreingang (52) zugeführt wird,
- wobei die Ausgangsspannung des Komparators (50) ein digitales Clocksignal darstellt, das auf den Eingang (41) der Einrichtung (40) zur Bereitstellung zweier Schaltschwellen und auf die Gate-Anschlüsse des ersten und zweiten FET-Transistors (N1, P1) zurückgeführt wird.

2. Schaltungsanordnung nach Anspruch 1, die zusätzlich Mittel (30, 70) zur Einstellung der Frequenz des Ausgangssignals des Komparators (50) durch Beinflussung der Spannung am positiven Komparatoreingang (52) aufweist.

3. Schaltungsanordnung nach Anspruch 2, wobei die Mittel zur Einstellung der Frequenz durch eine Einrichtung (30) zur Steuerung des Stroms durch den ersten FET-Transistor (N1) und den zweiten FET-Transistor (P1) bereitgestellt werden.

4. Schaltungsanordnung nach Anspruch 3, die zusätzlich aufweist:
- eine erste Stromquelle (20) zur Bereitstellung eines Stroms für den ersten FET-Transistor (N1),
- eine zweite Stromquelle (10) zur Bereitstellung eines Stroms durch den zweiten FET-Transistor (P1), wobei
- die Einrichtung (30) zur Steuerung des Stroms die erste Stromquelle (20) und die zweite Stromquelle (10) steuert.

5. Schaltungsanordnung nach Anspruch 2, wobei die Mittel zur Einstellung der Frequenz durch eine Einrichtung (70) zur Einstellung der Kapazität (60) bereitgestellt werden.

6. Schaltungsanordnung nach Anspruch 5, wobei die Kapazität (60) aus einer Mehrzahl von Teilkapazitäten (61, 62, 63) besteht, die mittels Schalter (S1, S2) parallel zueinander schaltbar sind, und die Einrichtung (70) zur Einstellung der Kapazität Teilkapazitäten zu- oder wegschaltet.

7. Schaltungsanordnung nach Anspruch 5, wobei die Einrichtung (70) zur Einstellung der Kapazität in zeitlichen Abständen einen Vergleich der aktuellen Frequenz des Clocksignals mit einer Referenzfrequenz vornimmt.

8. Schaltungsanordnung nach Anspruch 3, wobei die Einrichtung (30) zur Steuerung des Stroms durch den ersten FET-Transistor (N1) und den zweiten FET-Transistor (P1) in zeitlichen Abständen einen Vergleich der aktuellen Frequenz des Clocksignals mit einer Referenzfrequenz vornimmt.

9. Schaltungsanordnung nach Anspruch 1, wobei die Ströme durch den ersten FET-Transistor (N1) und den zweiten FET-Transistor (P1) betragsmäßig gleich sind.

10. Schaltungsanordnung nach Anspruch 1, wobei der erste FET-Transistor (N1) und der zweite FET-Transistor (P1) komplementär zueinander ausgebildet sind.

11. Schaltungsanordnung nach Anspruch 1, wobei die Einrichtung zur Bereitstellung zweier Schaltschwellen durch einen Inverter (40) bereitgestellt wird, dessen Eingang (41) durch das Clocksignal getaktet ist.

12. Schaltungsanordnung nach Anspruch 1, wobei die einzelnen Bauelemente in CMOS-Technologie ausgeführt sind.

## Claims

1. Circuit arrangement for generating a digital clock signal having:
- a transistor circuit having
o a first, n-channel FET transistor (N1) and
o a second, p-channel FET transistor (P1),
o which are connected in series,
- a comparator (50) having a positive comparator input (52), a negative comparator input (51) and a comparator output (53),
- a device (40) for providing two switching thresholds, which, at its output (42), alternatively provides two switching thresholds for the comparator (50), the output (42) of the device (40) being connected to the negative input (51) of the comparator (50), and
- a capacitance (60), which is alternately charged and discharged via the two FET transistors (N1, P1), the voltage present at the capacitance (C) being fed to the positive comparator input (52),
- the output voltage of the comparator (50) representing a digital clock signal, which is fed back to the input (41) of the device (40) for providing two switching thresholds and to the gate terminals of the first and second FET transistors (N1, P1).

2. Circuit arrangement according to Claim 1, which additionally has means (30, 70) for setting the frequency of the output signal of the comparator (50) by influencing the voltage at the positive comparator input (52).

3. Circuit arrangement according to Claim 2, the means for setting the frequency being provided by a device (30) for controlling the current through the first FET transistor (N1) and the second FET transistor (P1).

4. Circuit arrangement according to claim 3, which additionally has:
- a first current source (20) for providing a current for the first FET transistor (N1),
- a second current source (10) for providing a current through the second FET transistor (P1),
- the device (30) for controlling the current controlling the first current source (20) and the second current source (10).

5. Circuit arrangement according to Claim 2, the means for setting the frequency being provided by a device (70) for setting the capacitance (60).

6. Circuit arrangement according to Claim 5, the capacitance (60) comprising a plurality of partial capacitances (61, 62, 63), which can be connected in parallel with one another by means of switches (51, 52), and the device (70) for setting the capacitance connects partial capacitances in or out.

7. Circuit arrangement according to Claim 5, the device (70) for setting the capacitance performing a comparison of the present frequency of the clock signal with a reference frequency at time intervals.

8. Circuit arrangement according to claim 3, the device (30) for controlling the current through the first FET transistor (N1) and the second FET transistor (P1) performing a comparison of the present frequency of the clock signal with a reference frequency at time intervals.

9. Circuit arrangement according to Claim 1, the currents through the first FET transistor (N1) and the second FET transistor (P1) being identical in terms of magnitude.

10. Circuit arrangement according to Claim 1, the first FET transistor (N1) and the second FET transistor (P1) being designed in complementary fashion with respect to one another.

11. Circuit arrangement according to Claim 1, the device for providing two switching thresholds being provided by an inverter (40), whose input (41) is clocked by the clock signal.

12. Circuit arrangement according to Claim 1, the individual components being embodied in CMOS technology.

## Revendications

1. Circuit pour la production d'un signal d'horloge numérique, comprenant :
- un circuit de transistors avec
° un premier transistor FET à canal n (N1), et
° un deuxième transistor FET à canal p (P1),
° qui sont branchés en série,
- un comparateur (50) avec une entrée de comparateur positive (52), avec une entrée de comparateur négative (51) et avec une sortie de comparateur (53),
- un dispositif (40) pour la fourniture de deux seuils de commutation qui fournit alternativement à sa sortie (42) deux seuils de commutation pour le comparateur (50), la sortie (42) du dispositif (40) étant reliée à l'entrée négative (51) du comparateur (50), et
- une capacité (60) qui est chargée et déchargée en alternance par l'intermédiaire des deux transistors FET (N1, P1), la tension présente à la capacité (C) étant envoyée à l'entrée de comparateur positive (52),
- la tension de sortie du comparateur (50) fournissant un signal d'horloge numérique qui est renvoyé à l'entrée (41) du dispositif (40) pour la fourniture de deux seuils de commutation et aux bornes de grille du premier et du deuxième transistor FET (N1, P1).

2. Circuit selon la revendication 1, qui comporte en plus des moyens (30, 70) pour le réglage de la fréquence du signal de sortie du comparateur (50) en influençant la tension à l'entrée de comparateur positive (52).

3. Circuit selon la revendication 2, dans lequel les moyens pour le réglage de la fréquence sont fournis par un dispositif (30) pour la commande des courants passant dans le premier transistor FET (N1) et dans le deuxième transistor FET (P1).

4. Circuit selon la revendication 3, qui comporte en plus:
- une première source de courant (20) pour la fourniture d'un courant pour le premier transistor FET (N1),
- une deuxième source de courant (10) pour la fourniture d'un courant passant dans le deuxième transistor FET (P1),
- le dispositif (30) pour la commande du courant commandant la première source de courant (20) et la deuxième source de courant (10).

5. Circuit selon la revendication 2, dans lequel les moyens pour le réglage de la fréquence sont fournis par un dispositif (70) pour le réglage de la capacité (60).

6. Circuit selon la revendication 5, dans lequel la capacité (60) est constituée de plusieurs capacités partielles (61, 62, 63) qui peuvent être branchées en parallèle les unes avec les autres au moyen de commutateurs (S1, S2) et dans lequel le dispositif (70) pour le réglage de la capacité branche ou débranche des capacités partielles.

7. Circuit selon la revendication 5, dans lequel le dispositif (70) pour le réglage de la capacité effectue à des intervalles temporels déterminés une comparaison de la fréquence actuelle du signal d'horloge avec une fréquence de référence.

8. Circuit selon la revendication 3, dans lequel le dispositif (30) pour la commande du courant passant dans le premier transistor FET (N1) et dans le deuxième transistor FET (P1) effectue à des intervalles temporels déterminés une comparaison de la fréquence actuelle du signal d'horloge avec une fréquence de référence.

9. Circuit selon la revendication 1, dans lequel les courants passant dans le premier transistor FET (N1) et dans le deuxième transistor FET (P1) sont égaux en valeur absolue.

10. Circuit selon la revendication 1, dans lequel le premier transistor FET (N1) et le deuxième transistor FET (P1) sont conçus complémentaires l'un de l'autre.

11. Circuit selon la revendication 1, dans lequel le dispositif pour la fourniture des deux seuils de commutation est fourni par un inverseur (40) dont l'entrée (41) est soumise au signal d'horloge.

12. Circuit selon la revendication 1, dans lequel les différents composants sont réalisés en technologie CMOS.
